# DEMANDE DE BREVET EUROPEEN

(11) **EP 1 742 261 A1**
(43) Date de publication de la demande: **10.01.2007**
(21) Numéro de dépôt: 06291077.3
(22) Date de dépôt: 29.06.2006
(51) Int. Cl.: H01L 21/768

(54) **Realisation d'une barriere CuSIN autoalignee**

(30) Priorité: 07.07.2005 FR 0507269
(71) Demandeur: STMICROELECTRONICS SA, 92120 Montrouge (FR)
(72) Inventeur: Caubet, Pierre, 38420 Le Versoud (FR); Casanova, Nicolas, 38920 Crolles (FR)
(74) Mandataire: Loisel, Bertrand

(57) **Abrégé**

Un produit semiconducteur comprenant une portion en cuivre, une portion en un matériau diélectrique, et une barrière auto-alignée entre la portion en cuivre et la portion en matériau diélectrique. La barrière auto-alignée comprend une première couche de siliciure de cuivre comprenant en majorité des premières molécules de siliciure de cuivre, et une seconde couche de siliciure de cuivre comprenant en majorité des secondes molécules de siliciure de cuivre. La proportion du nombre d'atomes de silicium est plus élevée dans les secondes molécules que dans les premières molécules.

## Description

La présente invention se rapporte à la réalisation des barrières auto-alignées en microélectronique, par exemple dans des circuits intégrés.

Les circuits intégrés comprennent généralement des barrières à l'interface entre une zone conductrice et une zone isolante. Les barrières permettent par exemple d'empêcher la diffusion d'atomes depuis la zone conductrice vers la zone isolante.

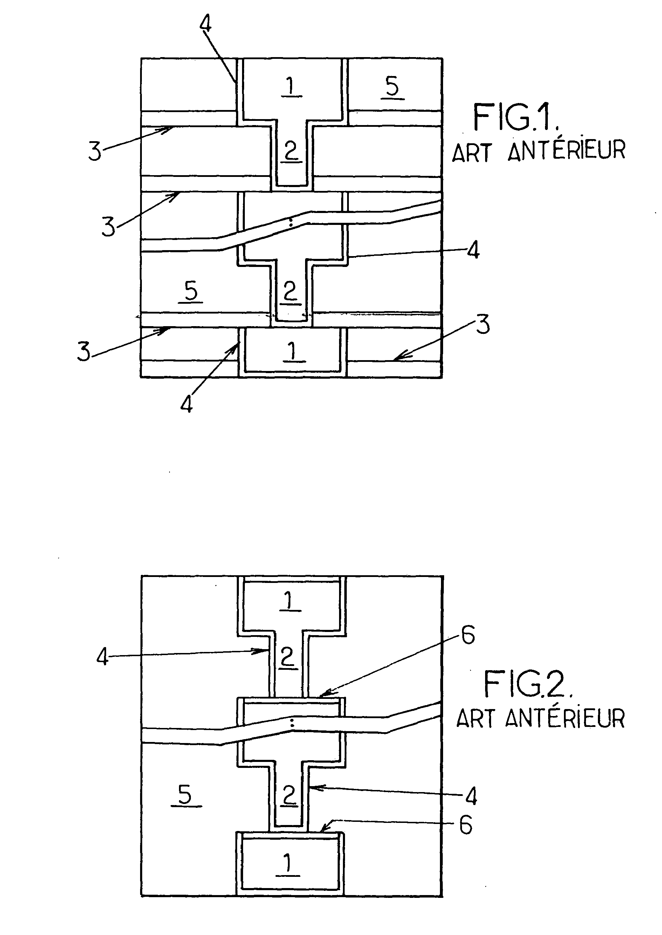

La figure 1 est un schéma d'un exemple de portion de circuit selon l'art antérieur. Des zones conductrices 1 et des via 2 sont séparés d'un diélectrique 5 par des barrières métalliques 4 et par des barrières de nitrure de silicium (Si₃N₄) 3. Les zones conductrices 1 et les via 2 sont classiquement réalisées en cuivre. Le diélectrique 5 peut par exemple comprendre de l'oxyde de silicium dopé au fluor (« Fluorosilicate Glass » en anglais ou FSG).

Lorsqu'une plaquette d'un tel circuit est fabriquée, les barrières de nitrure de silicium 3 sont déposées sur toute la surface de la plaquette. Aussi, des opérations de gravure des barrières de nitrure de silicium 3 sont-elles nécessaires pour créer les emplacements destinés aux via 2.

De plus, lorsqu'une barrière de nitrure de silicium est déposée sur toute la surface de la plaquette, comme sur le schéma de la figure 1, il est procédé au préalable à une étape de désoxydation du cuivre. En effet, l'oxyde de cuivre est relativement poreux et cassant, ce qui facilite la diffusion des atomes de cuivre. Aussi, lorsqu'un courant relativement élevé est appliqué au circuit, les atomes de cuivre seront relativement peu retenus. Un tel courant peut être appliqué afin de tester la résistance au vieillissement de circuit. En conséquence, une caractéristique de résistance au vieillissement d'une telle plaquette risque d'être insatisfaisante, si le cuivre n'est pas correctement désoxydé avant la formation de la barrière.

Le brevet américain US 6,181,013 décrit un procédé permettant d'obtenir une couche comprenant des molécules de siliciure de cuivre. Une plaquette comprenant à sa surface des portions de diélectrique et des portions de cuivre est tout d'abord nettoyée. Un plasma d'azote, d'ammoniac et de silane est ensuite appliqué. Cette opération est réalisée à 400°C environ. Ce plasma conduit à déposer du nitrure de silicium sur toute la surface de la plaquette. Le nitrure de silicium déposé sur les portions de cuivre peut réagir avec le cuivre pour former une couche comprenant des molécules de siliciure de cuivre.

Dans des applications de type imageur, des rayons lumineux doivent traverser une partie du circuit. Des barrières de nitrure de silicium réparties sur toute la surface, présentent l'inconvénient que les rayons lumineux sont partiellement réfractés du fait de la différence d'indice optique entre le diélectrique et le nitrure de silicium. Le nitrure de silicium présente en effet un indice optique significativement plus élevé que les autres diélectriques utilisés.

La figure 2 est un schéma d'un autre exemple de portion de circuit selon l'art antérieur. Des zones conductrices 1 et des via 2 sont séparés d'un diélectrique 5 par des barrières métalliques 4 et par des barrières auto-alignées 6. Les zones conductrices 1 et les via 2 sont classiquement réalisés en cuivre. Le diélectrique 5 peut par exemple comprendre du FSG. Les barrières auto-alignées 6 sont formées uniquement sur le cuivre.

Les barrières auto-alignées occupent seulement une partie de la surface de la plaquette et permettent ainsi d'éviter les réfractions partielles des rayons lumineux dans des applications de type imageur.

Les barrières auto-alignées 6 peuvent par exemple comprendre du silicium, ou encore du cobalt.

Lorsqu'une barrière auto-alignée comprenant du silicium est formée sur du cuivre, des phénomènes de diffusion entre des atomes de cuivre et des atomes de silicium de la barrière auto-alignée génèrent une couche mixte de siliciure de cuivre à la surface du cuivre. Cette couche mixte permet de mieux retenir les atomes de cuivre lorsqu'un courant relativement élevé est appliqué au circuit. Un tel courant peut être appliqué afin de tester la résistance au vieillissement du circuit. En conséquence, une barrière auto-alignée comprenant du silicium permet d'améliorer une caractéristique de résistance au vieillissement du circuit.

Cet avantage est également obtenu avec une barrière auto-alignée comprenant du cobalt. En effet, le cobalt et le cuivre ne se mélangent que pour des températures relativement élevées, supérieures à 422°C. Une barrière auto-alignée comprenant du cobalt forme donc une bonne barrière à la diffusion des atomes de cuivre. Cette barrière permet de retenir les atomes de cuivre lorsqu'un courant relativement élevé est appliqué.

Les barrières auto-alignées comprenant du cobalt sont fabriquées par trempage de la plaquette dans une solution. La solution réagit avec le cuivre, de sorte que la barrière ne se forme qu'à la surface du cuivre. Un tel procédé nécessite donc une préparation de la surface de la plaquette, ainsi qu'un contrôle de certains paramètres, comme la température et le pH.

A l'inverse, les barrières auto-alignées comprenant du silicium sont relativement faciles à mettre en oeuvre, car leur fabrication fait intervenir des équipements existants.

L'article « A Novel Self-Aligned Surface-Silicide Passivation technology for Reliability Enhancement in Copper Interconnects », T.Takewaki, 1995 Symposium on VLSI Technology Digest of Technical Papers, décrit un procédé de formation d'une barrière auto-alignée. Une plaquette est tout d'abord nettoyée par un recuit à 500°C, puis du silane est introduit sans plasma à une température entre 150°C et 200°C. Il est précisé que cette température pourrait atteindre 400°C. Le cuivre agit comme un catalyseur dans la réaction de décomposition du silane en silicium, de sorte que du silicium est formé à la surface du cuivre. La plaquette subit ensuite un recuit à 450°C pendant 30 minutes afin de former une couche auto-alignée de siliciure de cuivre.

L'article « Passivation of Copper by Silicide Formation in Dilute Silane », S. Hyme, Journal of Applied Physics, Vol. 71 pages 4623-4625, (1992), décrit que la couche de siliciure peut comprendre des molécules de formule Cu₅Si, Cu₁₅Si₄ ou encore Cu₃Si.

La présente invention a pour objectif d'améliorer encore la caractéristique de résistance au vieillissement.

L'invention a pour objet un produit semiconducteur comprenant une portion en cuivre, une portion en un matériau diélectrique, et une barrière auto-alignée entre la portion en cuivre et la portion en matériau diélectrique. La barrière auto-alignée comprend une première couche de siliciure de cuivre comprenant des premières molécules de siliciure de cuivre, et une seconde couche de siliciure de cuivre comprenant des secondes molécules de siliciure de cuivre. La proportion d'atomes de silicium est plus élevée dans les secondes molécules que dans les premières molécules.

La barrière auto-alignée comprend ainsi deux couches de siliciure distinctes, ce qui permet de retenir davantage les atomes de cuivre que les barrières alignées selon l'art antérieur qui ne comprennent qu'une seule couche. Les atomes de cuivre de la portion en cuivre soumis à une tension relativement élevée se heurtent ainsi à deux couches de siliciure de cuivre. En conséquence, la caractéristique de résistance au vieillissement de la plaquette est améliorée relativement à l'art antérieur.

Par « produit semiconducteur », on entend un produit microélectronique comprenant un substrat. Le substrat est classiquement réalisé en silicium monocristallin dopé, mais peut également être réalisé en d'autres matériaux. Par exemple, le substrat peut être souple.

Avantageusement, la seconde couche de la barrière se situe entre la portion en cuivre et la première couche de la barrière. La couche la plus concentrée en silicium est ainsi la plus proche de la portion en cuivre. L'invention n'est pas limitée par les positions relatives de la première couche et de la seconde couche.

Avantageusement, les secondes molécules de la seconde couche ont une stoechiométrie telle que la proportion en nombre d'atomes de silicium est supérieure à un tiers. La seconde couche peut ainsi comprendre en majorité des molécules de formule Cu₂Si, ou CuSi. La seconde couche est ainsi relativement chargée en atomes de silicium, ce qui participe à la rétention des atomes de cuivre de la portion de cuivre.

L'invention n'est pas limitée par les stoechiométries ni des premières molécules ni des secondes molécules.

L'invention a également pour objet un imageur comprenant une microlentille, une photodiode, et au moins un produit semiconducteur selon un aspect de l'invention.

L'invention a également pour objet une bobine comprenant un produit semiconducteur selon un aspect de l'invention, la portion en cuivre comprenant des lignes en cuivre de la bobine.

Un tel imageur ou une telle bobine représentent des exemples d'application de la présente invention et ne limitent en rien la portée de l'invention.

La présente invention a également pour objet un procédé de formation d'une barrière auto-alignée à la surface d'une portion en cuivre d'une plaquette de produit semiconducteur, comprenant une étape de désoxydation de la plaquette pour éliminer des atomes d'oxygène de la surface de la plaquette, une étape de siliciuration avec du silane introduit sous atmosphère, à température supérieure à 350°C, et une étape de traitement par un plasma azoté.

Ce procédé permet d'obtenir, de façon surprenante, une barrière auto-alignée comprenant deux couches de siliciure, l'une des couches étant plus concentrée en silicium que l'autre couche. Le procédé permet donc de fabriquer le produit semiconducteur selon un aspect de l'invention.

Avantageusement, la température a une valeur dans une plage entre 350°C et 420°C, par exemple 400°C.

D'autres particularités et avantages de la présente invention apparaîtront dans la description ci-après.
La figure 1, déjà commentée, est un schéma d'un exemple de portion de circuit selon l'art antérieur.
La figure 2, déjà commentée, est un schéma d'un autre exemple de portion de circuit selon l'art antérieur.
La figure 3 est une représentation schématique d'un exemple de portion de produit semiconducteur selon un mode de réalisation de la présente invention.
La figure 4 est un organigramme d'un exemple de procédé de formation d'une barrière auto-alignée selon un mode de réalisation préféré de la présente invention.
La figure 5 montre une portion d'un exemple d'imageur selon un mode de réalisation de la présente invention.
La figure 6 montre une portion de bobine selon un mode de réalisation de la présente invention.

### Barrière auto-alignée à deux couches

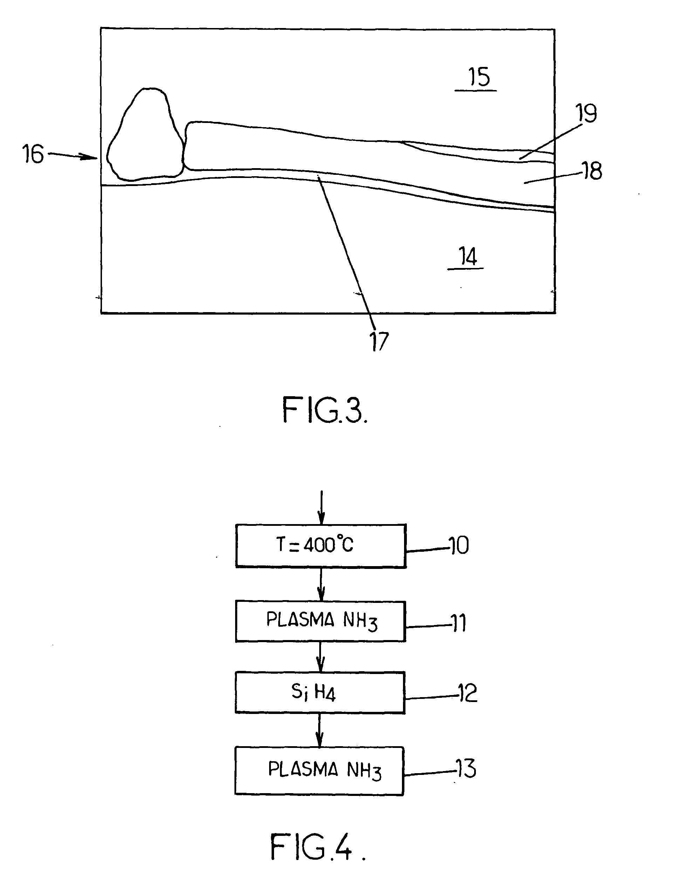

Le produit semiconducteur représenté sur la figure 3 comprend une portion en cuivre 14 et une portion en un matériau diélectrique 15, par exemple du FSG. La portion de cuivre 14 de la figure 3 occupe la totalité de la longueur de la portion de produit semiconducteur représentée. Toutefois, la portion de cuivre n'occupe en général qu'une partie de la surface d'une plaquette. Typiquement, la portion de cuivre fait partie des voies de conduction du courant dans un circuit microélectronique.

Une barrière auto-alignée 16 se situe entre la portion de cuivre 14 et le matériau diélectrique 15. La barrière auto-alignée est formée uniquement sur les portions de cuivre. Cette barrière auto-alignée comprend une première couche de siliciure de cuivre 18 et une deuxième couche de siliciure de cuivre 17. La première couche 18 comprend en majorité des premières molécules de siliciure de cuivre. La deuxième couche 17 comprend en majorité des secondes molécules de siliciure de cuivre.

Par « en majorité », on entend que la première couche 18 (respectivement la seconde couche 17) peuvent comprendre, outre les premières molécules de siliciure de cuivre (respectivement les secondes molécules de siliciure de cuivre), et en proportions moindres, d'autres molécules. Ces autres molécules peuvent comprendre des molécules de siliciure de cuivre différentes des premières molécules de siliciure de cuivre (respectivement des secondes molécules de siliciure de cuivre). Ces autres molécules peuvent également comprendre des molécules comprenant de l'azote, ou du carbone etc. La proportion de ces autres molécules dans la première couche (respectivement la seconde couche) peut ne pas être négligeable.

La proportion du nombre d'atomes de silicium est plus élevée pour les secondes molécules que pour les premières molécules. Les premières molécules de siliciure peuvent être des molécules de formule Cu₃Si, et les secondes molécules de siliciure peuvent être des molécules de formule Cu₂Si, en particulier lorsque la barrière auto-alignée 16 est relativement mince.

Ainsi, les secondes molécules ont une stoechiométrie telle que la proportion en nombre d'atomes de silicium est égale à un tiers. Cette proportion relativement élevée permet de mieux retenir encore les atomes de cuivre lorsqu'ils sont soumis à une tension relativement élevée.

Alternativement, les premières molécules de siliciure peuvent être des molécules de formule Cu₂Si, et les secondes molécules de siliciure peuvent être des molécules de formule CuSi, en particulier lorsque la barrière auto-alignée 16 est relativement épaisse. Ainsi, les secondes molécules ont une stoechiométrie telle que la proportion en nombre d'atomes de silicium est égale à un demi.

La seconde couche 17 se situe entre la portion de cuivre et la première couche 18. La seconde couche 17 peut présenter une densité massique plus faible que la densité massique de la première couche.

Du fait de la présence de deux couches de siliciure de cuivre, la barrière auto-alignée 16 permet de retenir relativement efficacement les atomes de cuivre de la couche de cuivre 14.

La barrière auto-alignée 16 peut avoir une épaisseur de l'ordre de 10 à 30 nm.

Des atomes d'azote peuvent être déposés sur la première couche 18 et former une troisième couche 19. La barrière auto-alignée 16 peut également comprendre des atomes de carbone, d'oxygène etc.

Une telle barrière auto-alignée peut être formée par le procédé illustré sur la figure 4.

### Procédé de formation d'une barrière auto-alignée

La figure 4 est un organigramme d'un exemple de procédé de formation d'une barrière auto-alignée selon un mode de réalisation préféré de la présente invention. Le procédé selon cet aspect de l'invention comprend une étape de désoxydation, une étape de siliciuration et une étape de traitement par un plasma azoté, respectivement référencées 11, 12 et 13 sur l'organigramme de la figure 4.

L'étape de désoxydation 11 permet de désoxyder la surface des portions de cuivre. En effet, s'il reste des atomes d'oxygène à la surface des portions de cuivre, des molécules d'oxyde de silicium (SiO₂) se forment lors de la décomposition du silane à l'étape de siliciuration 12, ce qui empêche la diffusion des atomes de silicium dans le cuivre. En conséquence, une caractéristique de résistance au vieillissement d'une telle plaquette risque de ne pas être optimale.

La présente invention n'est pas limitée par la manière dont l'étape de désoxydation est mise en oeuvre. Par exemple, la désoxydation peut être effectuée par un recuit sous dihydrogène à 500°C, ou par nettoyage humide.

Dans le mode de réalisation préféré, l'étape de désoxydation 11 est réalisée à l'aide d'un plasma d'ammoniac (NH₃). L'ammoniac peut être dilué dans du diazote (N₂) afin de renforcer la réactivité du plasma. Le plasma d'ammoniac permet de désoxyder la surface des portions de cuivre. De plus, la plaquette reste sous vide dans le réacteur après cette étape de désoxydation 11, ce qui permet d'éviter une éventuelle contamination par le dioxygène de l'air ambiant.

Dans ce mode de réalisation, l'étape de désoxydation 11 est précédée d'une étape non représentée pendant laquelle la plaquette est introduite dans le réacteur. La température de la plaquette est stabilisée lors d'une étape de thermalisation 10.

Dans cet exemple, la température du réacteur est maintenue en permanence à 400°C.

Après l'étape de désoxydation 11 et une étape de pompage du gaz non représentée, du silane (SiH₄) est introduit dans la chambre sous atmosphère, c'est à dire sans plasma. Le cuivre à la surface des portions de cuivre agit comme un catalyseur dans une réaction de décomposition du silane. Le silane se décompose donc de façon sélective sur la surface des portions de cuivre. Cette étape de siliciuration 12 est réalisée à une température supérieure à 350°C. Dans le mode de réalisation préféré, le réacteur a une température de 400°C environ, la température effective de la plaquette étant en général inférieure, par exemple entre 350°C et 400°C.

Dans le mode de réalisation préféré, le silane est dilué dans du diazote lors de l'étape de siliciuration. Par exemple, le silane est dilué à 1% dans le diazote.

De la durée de cette étape dépend l'épaisseur de la barrière auto-alignée formée. Avantageusement, la durée de cette étape de siliciuration 12 est d'environ une dizaine de secondes.

L'étape de traitement par un plasma azoté 13 permet de figer les atomes de silicium de la barrière auto-alignée ainsi formée. Ainsi, si par la suite la plaquette est chauffée à des températures relativement élevées, la diffusion des atomes de silicium dans la portion de cuivre est ralentie, ou même bloquée. On évite ainsi d'augmenter la résistance électrique de la portion de cuivre. De plus, les atomes d'azote qui se déposent à la surface de la barrière auto-alignée permettent d'augmenter la dureté de la barrière. La barrière auto-alignée est ainsi plus résistante à la gravure et globalement plus stable.

L'étape 13 est réalisée à l'aide d'un plasma azoté, c'est à dire un plasma comprenant des atomes d'azote. Dans le mode de réalisation préféré, on utilise un plasma d'ammoniac. Le plasma d'ammoniac est en effet particulièrement réactif. On peut bien entendu utiliser d'autres plasmas azotés, par exemple un plasma de diazote.

D'autres étapes peuvent être appliquées par la suite à la plaquette, en particulier une étape de dépôt d'un matériau diélectrique.

Le procédé selon le mode de réalisation préféré conduit, de façon surprenante, à une barrière auto-alignée comprenant deux couches de siliciure de cuivre, telle que la barrière auto-alignée illustrée par la figure 3.

Il est possible qu'une couche initiale de siliciure soit formée à l'issue de l'étape de siliciuration, et que, lors de l'étape suivante de traitement par un plasma azoté, une déplétion en atomes de silicium soit générée en surface et sur une certaine épaisseur de cette couche initiale. Ainsi, la première couche, moins chargée en atomes de silicium, serait formée par la partie de la couche initiale touchée par cette déplétion. La seconde couche correspondrait à la partie de la couche initiale de siliciure plus profonde et non touchée par la déplétion. Cette hypothèse expliquerait pourquoi la seconde couche, plus chargée en atomes de silicium, est située entre la portion de cuivre et la première couche.

### Exemple de mise en oeuvre du procédé

L'étape de thermalisation 10 peut être réalisée sous une pression de 560 Pascal environ (soit 4,2 Torr environ), sous une atmosphère de diazote. La durée de l'étape de thermalisation 10 peut-être d'environ 180 secondes.

Dans ce mode de réalisation, l'étape de désoxydation 11 est réalisée sous une pression de 560 Pascal environ. La température du réacteur est d'environ 400°C, la température effective de la plaquette est en général inférieure, entre 350°C et 400°C. De l'ammoniac est introduit avec un débit d'environ 5. 10⁻⁷ m³/s (soit 30 cm³/min) et du diazote est introduit avec un débit d'environ 42. 10⁻⁶ m³/s (soit environ 2500 cm³/min). Une puissance d'environ 150 W est appliquée de façon à créer un plasma. L'étape de désoxydation peut durer une dizaine de secondes.

L'étape de siliciuration 12 peut être réalisée sous une pression de 600 Pascal environ (soit 4,5 Torr environ). Par ailleurs le silane est dilué dans du diazote : le silane est par exemple introduit avec un débit de l'ordre de 6,7. 10-⁷ m³/s (soit environ 40 cm³/min) et le diazote est introduit avec un débit de l'ordre de 6,7.10⁻⁵ m³/s (soit environ 4000 cm³/min).

Une durée de l'ordre de la minute peut conduire à une épaisseur d'environ 2. 10⁻⁷ mètres (soit 2000 Å). Il est préférable, afin d'éviter de fortes déformations du réseau cristallin, d'avoir une épaisseur de barrière auto-alignée plus faible. Ainsi, une durée de l'ordre de la dizaine de secondes peut conduire à une épaisseur d'environ 3,6. 10⁻⁸ mètres (soit 360 Å).

Lors de l'étape de traitement par un plasma azoté 13, de l'ammoniac peut être introduit, par exemple avec un débit de 2,4. 10⁻⁶ m³/s (soit environ 145 cm³/min). Une puissance d'environ 500 W peut être appliquée.

L'étape 13 peut être réalisée sous une pression de 600 Pascal environ (soit 4,5 Torr environ). Elle peut avoir une durée de par exemple 60 secondes.

### Exemple d'applications

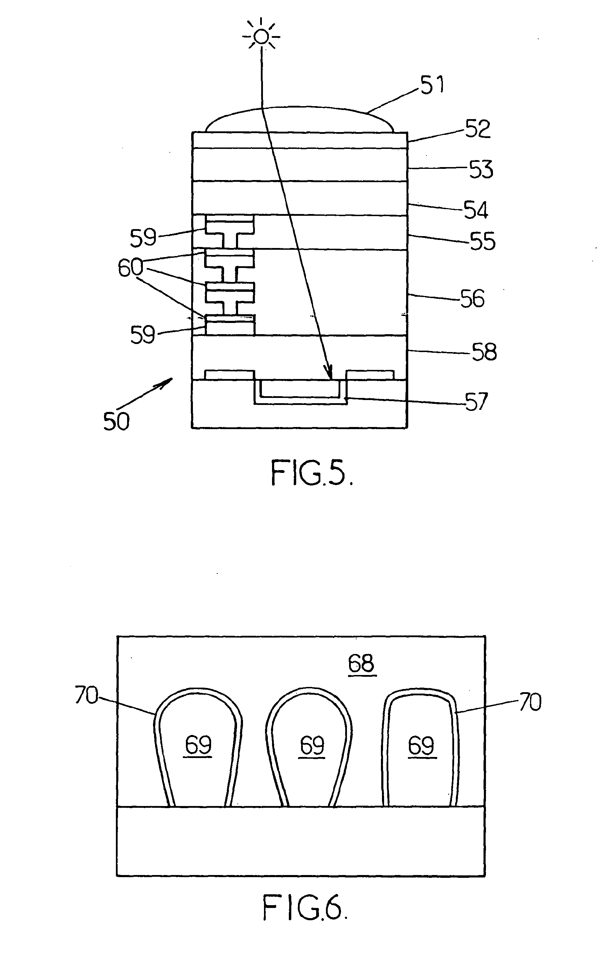

La figure 5 montre une portion d'un exemple d'imageur selon un mode de réalisation de la présente invention.

La portion d'imageur 50 représentée comprend une microlentille 51, une photodiode 57. Un rayon lumineux, représenté par une flèche, est dévié par la microlentille 51 et atteint la photodiode 57 après avoir traversé diverses strates. Les strates traversées peuvent comprendre une strate de planarisation 52, un film coloré 53, une strate de passivation 54, et une pluralité de strates diélectriques 55, 56, 58. La pluralité de strates diélectriques comprend deux strates de dioxyde de silicium non dopé (« undoped silicon glass » en anglais, ou USG) 55, 58 et une strate de FSG 56.

L'imageur 50 comprend également des portions en cuivre 59. Ces portions en cuivre comprennent par exemple des voies de conduction électrique ainsi que des via entre ces voies. Des barrières auto-alignées 60 à deux couches de siliciure de cuivre (non représentées), selon un aspect de l'invention, se situent entre les portions en cuivre et du matériau diélectrique. Ces barrières auto-alignées 60 ne sont déposées que sur les portions en cuivre 59. Le rayon lumineux ne traverse ainsi pas les barrières auto-alignées. L'USG et le FSG ont respectivement des indices optiques de 1,45 et de 1,44. Ces indices sont relativement proches l'un de l'autre, de sorte que le rayon lumineux n'est que très partiellement réfracté en traversant les strates diélectriques 55, 56, 58.

La figure 6 montre une portion de bobine selon un mode de réalisation de la présente invention. Sont représentées des portions de lignes de cuivre 69 formant la bobine. Ces lignes de cuivre sont noyées dans un matériau diélectrique 68, par exemple du benzocyclobutène (BCB). Des barrières auto-alignées 70 se situent entre les portions de cuivre 69 et le diélectrique 68.

Ces barrières auto-alignées peuvent être formées en appliquant le procédé selon un aspect de l'invention. Une barrière auto-alignée formée sur la surface de la portion de cuivre par catalyse présente une épaisseur sensiblement égale sur toute la surface. Cette propriété peut être particulièrement intéressante lorsque cette surface est courbe, comme c'est le cas pour des lignes de bobine.

De plus, ces barrières auto-alignées permettent de retenir relativement efficacement les atomes de cuivre des lignes 69.

## Revendications

1. Produit semiconducteur comprenant
une portion en cuivre,
une portion en un matériau diélectrique,
une barrière auto-alignée entre la portion en cuivre et la portion en matériau diélectrique, la barrière auto-alignée comprenant
• une première couche de siliciure de cuivre comprenant en majorité des premières molécules de siliciure de cuivre, et
• une seconde couche de siliciure de cuivre comprenant en majorité des secondes molécules de siliciure de cuivre, la proportion du nombre d'atomes de silicium étant plus élevée dans les secondes molécules que dans les premières molécules.

2. Produit semiconducteur selon la revendication 1, dans lequel
la seconde couche se situe entre la portion en cuivre et la première couche.

3. Produit semiconducteur selon l'une des revendications précédentes, dans lequel
les secondes molécules de siliciure de cuivre ont une stoechiométrie telle que la proportion du nombre d'atomes de silicium est supérieure à un tiers.

4. Imageur comprenant
une microlentille,
une photodiode, et
au moins un produit semiconducteur selon l'une des revendications précédentes.
5. Bobine comprenant
un produit semiconducteur selon l'une des revendications précédentes, la portion en cuivre comprenant des lignes en cuivre de la bobine.
6. Procédé de formation d'une barrière auto-alignée à la surface d'une portion en cuivre d'une plaquette de produit semiconducteur, comprenant une étape de désoxydation de la plaquette pour éliminer des atomes d'oxygène de la surface de la plaquette,
une étape de siliciuration avec du silane introduit sous atmosphère, à température supérieure à 350°C, et
une étape de traitement par un plasma azoté.
7. Procédé selon la revendication 6, dans lequel
le plasma azoté comprend un plasma d'ammoniac.
8. Procédé selon l'une des revendications 6 ou 7, dans lequel
l'étape de désoxydation est effectuée à l'aide d'un plasma d'ammoniac.
9. Procédé selon l'une des revendications 6 à 8, dans lequel
l'étape de siliciuration dure environ une dizaine de secondes.
10. Procédé selon l'une des revendications 6 à 9, dans lequel
le silane est dilué dans du diazote lors de l'étape de siliciuration.
